Europäisches Patentamt

European Patent Office

Office européen des brevets

(19)

(11) Numéro de publication : **0 325 524 B1**

(12) **FASCICULE DE BREVET EUROPEEN**

(45) Date de publication du fascicule du brevet :
**11.11.92 Bulletin 92/46**

(51) Int. Cl.⁵ : **G11C 27/04, G11C 19/28**

(21) Numéro de dépôt : **89400129.6**

(22) Date de dépôt : **17.01.89**

(54) **Mémoire à transfert de charges et procédé de fabrication de cette mémoire.**

(30) Priorité : **19.01.88 FR 8800542**

(43) Date de publication de la demande :
**26.07.89 Bulletin 89/30**

(45) Mention de la délivrance du brevet :
**11.11.92 Bulletin 92/46**

(84) Etats contractants désignés :
**DE FR GB NL**

(56) Documents cités :
**EP-A- 0 163 554**
**EP-A- 0 298 573**
**FR-A- 2 365 212**
**US-A- 4 654 865**
**PATENT ABSTRACTS OF JAPAN, vol. 9, no.
285 (P-404)[2008], 12 novembre 1985, page 137
P 404 ; & JP-A-61 125 999**

(73) Titulaire : **THOMSON-CSF**
**51, Esplanade du Général de Gaulle**
**F-92800 Puteaux (FR)**

(72) Inventeur : **Cazaux, Yvon**
**THOMSON-CSF SCPI**
**F-92045 PARIS LA DEFENSE CEDEX 67 (FR)**
Inventeur : **Blanchard, Pierre**
**THOMSON-CSF SCPI**
**F-92045 PARIS LA DEFENSE CEDEX 67 (FR)**
Inventeur : **Thenoz, Yves**
**THOMSON-CSF SCPI**
**F-92045 PARIS LA DEFENSE CEDEX 67 (FR)**
Inventeur : **Hérault, Didier**
**THOMSON-CSF SCPI**
**F-92045 PARIS LA DEFENSE CEDEX 67 (FR)**

(74) Mandataire : **Guérin, Michel et al**
**THOMSON-CSF SCPI**
**F-92045 PARIS LA DEFENSE CEDEX 67 (FR)**

**Description**

La présente invention concerne une mémoire à transfert de charges, ainsi qu'un procédé de fabrication de cette mémoire.

Elle s'applique notamment aux matrices photosensibles utilisées dans les systèmes vidéo. Dans ce type d'application, les charges stockées dans la mémoire proviennent d'éléments photosensibles. L'invention concerne plus particulièrement le transfert des charges stockées dans des registres à décalages, vers un registre de lecture.

Les mémoires à transfert de charges qu'elles soient utilisées pour enregistrer des charges provenant d'éléments photo-sensibles ou des charges générées par tout autre moyen, comportent généralement, de façon connue, une succession de registres de décalages, à transfert de charges, dans lesquels les charges stockées, sont transférées vers l'une des extrémités dite finale de chacun de ces registres, pour être transférées vers un registre de lecture, fonctionnant lui-même comme registre à décalages à transfert de charges. Les charges ainsi transférées des registres à décalages vers le registre de lecture, sont lues à l'extrémité de celui-ci, par un amplificateur de mesure.

Les registres de décalages utilisés dans cette mémoire sont parallèles à une première direction. Ces registres sont généralement de type "à quatre phases et à deux niveaux d'intégration d'électrodes ou de silicium polycristallin" le registre de lecture est parallèle à une deuxième direction, perpendiculaire à la première direction ; ce registre est comme on le verra plus loin en détail, dans le cas de l'invention, du type "à deux phases et à trois niveaux de silicium polycristallin".

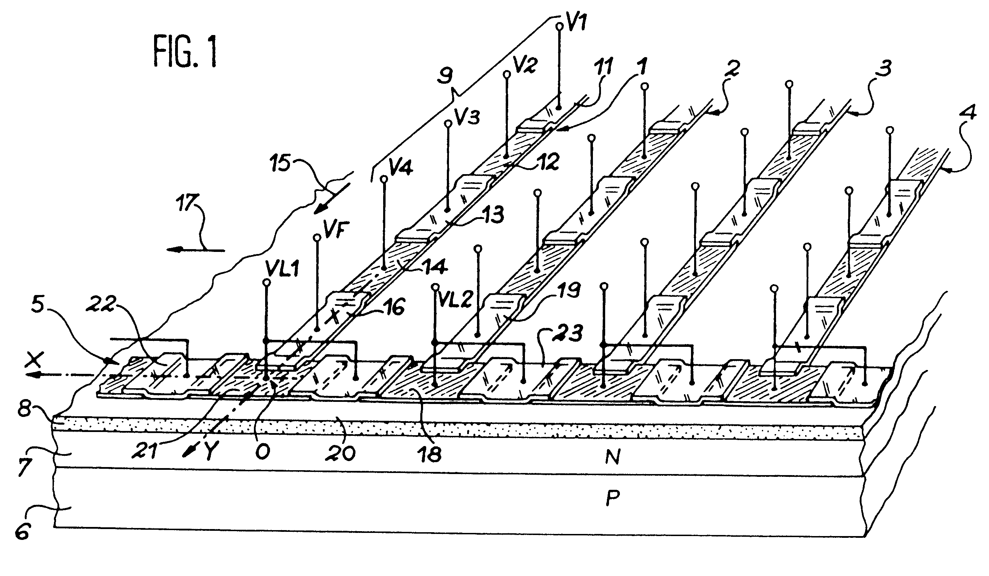

La figure 1 représente schématiquement et en perspective une mémoire à transfert de charges comportant de façon connue, des registres à décalages et un registre de lecture, à transfert de charges. Une telle mémoire est décrite par exemple dans le document EP-A-0 298 573 (Article 54(3)).

Les registres à décalages sont désignés par les références, 1, 2, 3, 4 et le registre de lecture est désigné par la référence 5. Le nombre des registres à décalages a été délimité à quatre, pour en faciliter la représentation. Ces registres à décalages sont parallèles à une première direction Y, tandis que le registre de lecture 5 est parallèle à une deuxième direction X, elle-même de préférence perpendiculaire à la première direction Y.

Les registres à décalages et le registre de lecture sont réalisés sur un substrat semi-conducteur dopé 6 d'un premier type (P par exemple), supportant une couche semi-conductrice 7 dopée d'un deuxième type (N par exemple). Une couche isolante 8 recouvre la couche semi-conductrice 7.

Chaque registre à décalages comporte, parallèlement à l'axe Y, des groupes successifs d'électrodes ; un seul groupe 9 de quatre électrodes a été représenté en exemple pour le registre 1. Il est évident que ce registre comporte d'autres groupes identiques au groupe 9, alignés avec celui-ci, dans la direction Y. Chacun de ces groupes comprend quatre électrodes 11, 12, 13 et 14 de transfert et de stockage de charges. Ces électrodes sont disposées en série et sont en contact avec la couche isolante 8. Elles permettent de faire circuler les charges, de manière connue, dans un sens prédéterminé indiqué par la flèche 15, grâce à des potentiels de transfert et des puits de potentiel apparaissant sous les électrodes de chaque groupe à l'interface entre la couche semi-conductrice 7 et la couche isolante 8, lorsque des tensions cycliques $V_1$, $V_2$, $V_3$ , $V_4$ sont appliquées respectivement aux quatre électrodes de chaque groupe. Ces tensions présentent respectivement des phases différentes et des valeurs extrêmes égales. Les charges sont ainsi transmises d'un groupe à un autre dans le sens de la flèche 15 pour être amenées à une extrémité de chaque registre à décalages qui se termine par une électrode finale de transfert 16. Cette électrode finale est portée à un potentiel cyclique, présentant par exemple la même phase et les mêmes valeurs extrêmes que la tension $V_1$ appliquée à la première électrode 11 du groupe.

Le registre 5 de lecture comporte, le long du deuxième axe X, pour chaque registre à décalages, et pour faire circuler les charges toujours dans un même sens, tel que défini par la flèche 17, une paire d'électrodes de lecture, en contact avec la couche isolante 8.

Chacune des paires d'électrodes de lecture comprend par exemple pour le registre à décalages 2 et pour transférer les charges stockées sous l'électrode finale 18 de ce registre, une électrode de stockage 18 dite de lecture, contiguë à l'électrode finale 19 du registre à décalages 2 considéré, et une électrode de transfert 20, dite de lecture, contiguë à l'électrode de stockage de lecture 18. Cette électrode de transfert est aussi contiguë à une électrode de stockage de lecture 21, correspondant à l'électrode finale 16 du registre à décalages adjacent 1, dans la succession de registres et dans le sens 17 du transfert des charges dans le registre de lecture.

De manière connue, la paire d'électrodes successives 20, 21 et 18, 23 du registre de lecture 5, sont respectivement alimentées par des tensions cycliques VL1, VL2, en opposition de phases et présentant les mêmes valeurs extrêmes.

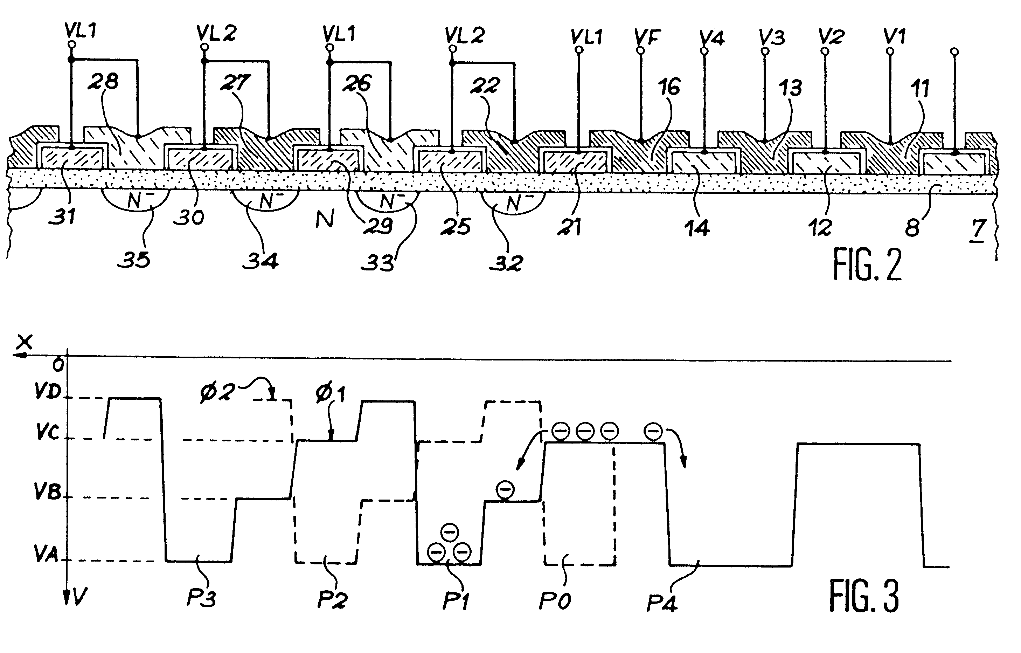

La figure 2 est une coupe schématique XOY de la mémoire de la figure 1. La structure de cette mémoire représentée ici de manière plus détaillée, et comme dans l'état de la technique. Les mêmes éléments portent les mêmes références sur cette figure et sur la figure 1.

On retrouve sur cette figure la couche semi-conductrice 7, dopée de deuxième type (N par exemple), la couche isolante 8 et, sur cette couche isolante, certaines des électrodes du registre de lecture 5 et certaines des électrodes du registre à décalage 1. C'est ainsi que sont représentées les électrodes 11, 2, 13, 14 du registre à décalages 1, auxquelles sont appliquées les tensions déphasées V1, V2, V3, V4. On distingue aussi l'électrode finale 16 de ce registre à décalages, à laquelle est appliquée la tension VF, l'électrode de stockage 21 du registre de lecture 5, l'électrode de transfert 22 qui est contiguë à cette électrode de stockage 21, ainsi qu'à l'électrode de stockage 25 suivante. On a également représenté sur cette figure, d'autres électrodes de transfert 26, 27, 28 et d'autres électrodes de stockage 29, 30, 31 du registre de lecture. Les paires d'électrodes telles que 21, 22, 25, 26, ... du registre de lecture sont alimentées par les tensions VI1, VI2 mentionnées plus haut.

Des zones semi-conductrices d'un troisième type (N⁻ par exemple), représentées en 32, 33, 34, 35 sur la figure, sont réalisées en regard des électrodes de transfert 22, 26, 27, 28, ... du registre de lecture.

Des charges provenant des registres à décalages circulent dans ce registre de lecture, grâce à des puits de potentiel et des potentiels de transfert apparaissant sous les paires successives telles que 22-25, ... d'électrodes du registre de lecture.

La figure 3 est un diagramme des potentiels V qui apparaissent à l'interface entre la couche semi-conductrice 7 et la couche isolante 8, lorsque les potentiels mentionnés plus haut sont appliqués aux électrodes du registre à décalages et aux électrodes du registre de lecture. Ces potentiels présentent, pour chacune des phases $\phi$1, $\phi$2 des tensions VI1, VI2 appliquées aux paires d'électrodes successives du registre de lecture, des puits de potentiels P1, P2, P3, de profondeur VA, et des paliers de potentiels de transfert, de valeurs VB, VC, VD.

Ces puits et ces potentiels de transfert permettent d'acheminer les charges dans le registre de lecture, dans le sens de la flèche 17 par exemple, ces charges provenant d'un puits de potentiel P4 du registre à décalages. Dans ce registre à décalages, ces charges sont amenées vers les extrémités de chaque registre à décalages grâce à l'application des potentiels V1, V2, V3, V4 aux différentes électrodes, et grâce à l'application du potentiel VF, à l'électrode finale 16 de ce registre (VF=V1).

Le potentiel de transfert, de niveau VC résultant de l'application du potentiel VF à l'électrode finale 16 du registre à décalages présente un niveau supérieur au potentiel de transfert VD résultant de l'application du potentiel VI1 à l'électrode 21.

Il en résulte que les charges (des électrons dans l'exemple considéré) sont normalement transférées du puits de potentiel P4 présent sous l'électrode de stockage 14 du registre à décalages, vers le puits de potentiel P0 présent sous l'électrode de stockage 21 du registre de lecture. Le potentiel de transfert VC créé par la tension VF appliquée à l'électrode finale 16, est le même que celui qui crée le puits de potentiel P0 pendant le transfert et des électrons présents dans le puits P1 du registre de lecture, peuvent retourner vers le puits P4 du registre de décalages (il est à noter que l'axe V des tensions est dirigé vers le bas). En fait, une fois le registre de lecture chargé, la tension VF reste à l'état bas et les potentiels VL1 et VL2 sont commandés entre les niveaux bas et haut afin d'évacuer les charges vers la sortie du registre de lecture (flèche 17, figure 1). C'est pendant ce décalage que des charges peuvent remonter vers le registre à décalage.

Le retour possible des charges circulant dans le registre de lecture, vers un registre à décalages est un très grave inconvénient de ce type de registre connu dans l'état de la technique.

L'invention a précisément pour but de remédier à cet inconvénient et notamment de réaliser une mémoire à transfert de charges, dans laquelle les charges qui circulent dans un registre de lecture ne peuvent absolument pas retourner vers les registres à décalages reliés à ce registre de lecture. Ces buts sont atteints de manière très simple, comme on le verra plus loin en détail, en implantant une zone dopée sous l'électrode finale de chaque registre à décalages, dans la couche semi-conductrice. Cette zone dopée est de même type (N⁻⁻ par exemple) que les zones dopées (N⁻) du registre de lecture, mais présente un dopage moins important. L'invention a aussi pour but de fournir un procédé simple de fabrication d'une telle mémoire, dans laquelle les registres à décalages sont des registres de type "quatre phases et deux niveaux de silicium polycristallin ou d'électrodes", et dans laquelle le registre de lecture est de type à "deux phases et trois niveaux de silicium polycristallin ou d'électrodes".

L'invention a pour objet une mémoire à transfert de charges comportant une succession de registres à décalages à transfert de charges dits à quatre phases et un registre de lecture des charges des registres à décalages dit à deux phases, ces registres à décalages et ce registre de lecture étant réalisés sur un substrat semi-conducteur dopé d'un premier type supportant une couche semi-conductrice dopée d'un deuxième type, elle-même recouverte par une couche isolante, chaque registre à décalages comportant en outre, parallèlement à un premier axe, des groupes successifs d'électrodes, comprenant chacun trois électrodes de transfert et une électrode de stockage des charges, en contact avec la couche isolante, pour faire circuler les charges dans un sens prédéterminé, grâce à des potentiels de transfert et des puits de potentiel apparaissant sous ces électrodes, en relation avec les quatre phases de tensions cycliques de valeurs identiques, appliquées respectivement aux électrodes de chaque groupe, les charges étant ainsi amenées à une extrémité du registre à décalages considéré qui se termine par une électrode finale de transfert, portée à un potentiel prédéterminé, le registre de lecture comportant, le long d'un deuxième axe, pour chaque registre à décalages, et pour faire circuler les charges toujours dans un même sens le long de ce deuxième axe, au moins une paire d'électrodes de lecture en contact avec la couche isolante, cette paire comprenant une électrode de stockage de lecture contiguë à l'électode finale du registre à décalages considéré, et une électrode de transfert de lecture contiguë à l'électrode de stockage de lecture correspondant au registre à décalages considéré, les électrodes de transfert de lecture situées entre deux registres à décalage étant adjacentes aux électrodes de stockage correspondant à ces registres, des zones semi-conductrices de troisième type étant réalisées respectivement en regard des électrodes de transfert du registre de lecture dans la couche semi conductrice, les charges circulant dans ce registre de lecture grâce à des puits de potentiel et des potentiels de transfert apparaissant sous les paires successives d'électrodes, chaque paire d'électrodes de lecture correspondant à un registre à décalages, étant alimentée par une tension cyclique présentant des valeurs égales mais en opposition de phases avec une tension cyclique alimentant la paire d'électrodes de lecture du registre à décalages adjacent dans ladite succession, caractérisé en ce que chaque registre à décalages comporte en outre une zone dopée de quatrième type, réalisée dans la couche dopée de deuxième type, en regard de l'électrode finale.

Selon une caractéristique préférée de l'invention, le substrat semi-conducteur de premier type est dopé de type P, la couche semi-conductrice de deuxième type est dopée de type N, les zones de troisième type étant dopées de type N , et présentant un dopage moins important que celui de la couche semi-conductrice de deuxième type N, chaque zone de quatrième type étant de type $N^{--}$ et présentant un dopage moins important que celui des zones dopées de troisième type $N^-$.

L'invention concerne aussi un procédé de fabrication d'une mémoire à transfert de charge, consistant à réaliser des électrodes de stockage du registre de lecture par masquage et gravure d'une première couche de silicium polycristallin dite de premier niveau, déposée sur la couche isolante, puis à implanter lesdites zones dopées de troisième type entre les électrodes de stockage du registre de lecture, dans la couche semi-conductrice dopée de deuxième type, puis à réaliser des électrodes de transfert du registre de lecture, et des électrodes de stockage et de transfert des registres à décalages, par masquage et gravure d'une deuxième couche de silicium polycristallin, dite de deuxième niveau, déposée sur les électrodes déjà réalisées dans la première couche et sur la couche isolante, caractérisé en ce qu'il consiste ensuite à réaliser une zone dopée de quatrième type dans la couche semi-conductrice de deuxième type, en regard d'espaces correspondant respectivement aux électrodes finales des registres à décalages, puis à réaliser d'autres électrodes de transfert du registre de lecture et d'autres électrodes de transfert et de stockage des registres à décalages, ainsi que les électrodes finales des registres à décalages, par masquage et gravure d'une troisième couche de silicium polycristallin, dite de troisième niveau, déposée sur les électrodes déjà réalisées dans les première et deuxième couches de silicium polycristallin et sur la couche isolante.

Les caractéristiques et avantages de l'invention ressortiront mieux de la description qui va suivre donnée en référence aux dessins annexés dans lesquels :

- la figure 1 a déjà été décrite et représente en perspective une vue d'ensemble schématique des principales électrodes des registres à décalages et d'un registre de lecture d'une mémoire connue dans l'état de la technique ; cette vue d'ensemble correspond aussi à celle de la mémoire de l'invention,

- la figure 2 a déjà été décrite et représente schématiquement et en coupe XOY, la structure de la mémoire de la figure 1, connue dans l'état de la technique,

- la figure 3 a déjà été décrite et représente schématiquement, un diagramme des potentiels apparaissant à l'interface entre la couche semi-conductrice et la couche isolante pour le registre de lecture et pour l'un des registres à décalages de la mémoire de la figure 2,

- la figure 4 représente schématiquement et en coupe XOY, la mémoire de la figure 1, dans le cas de l'invention,

- la figure 5 est un diagramme qui représente schématiquement, les potentiels intervenant à l'interface de la couche semi-conductrice et de la couche isolante, pour l'un des registres à décalages et pour le registre de lecture, dans la mémoire de la figure 4 conforme à l'invention,

- les figures 6 à 11 représentent schématiquement les étapes essentielles du procédé de fabrication de la mémoire de l'invention.

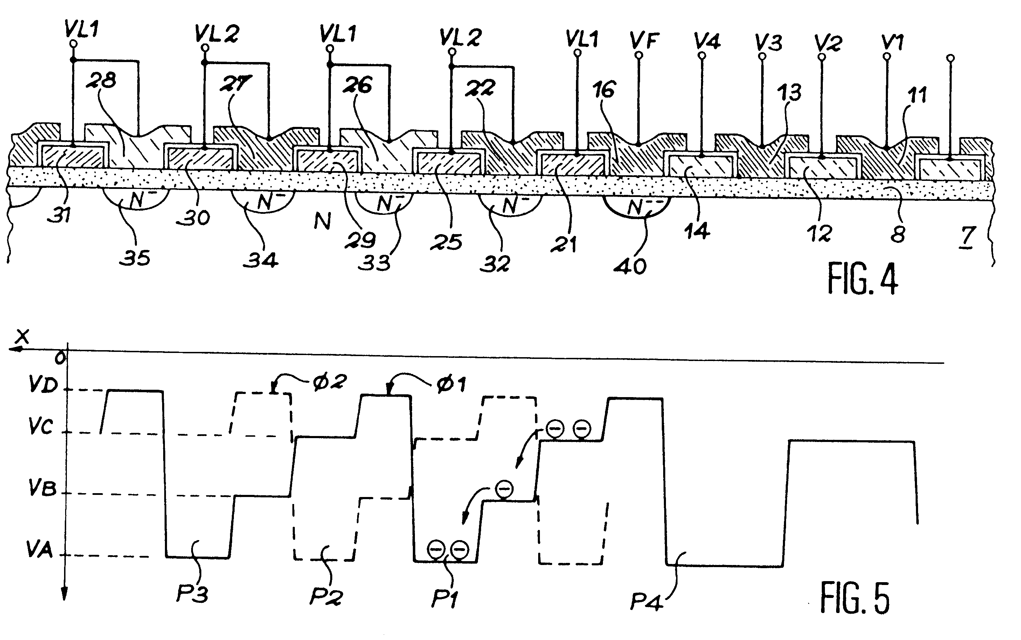

La figure 4 représente schématiquement et en coupe XOY, la mémoire de la figure 1, dans le cas de l'invention. Les mêmes éléments portent les mêmes références sur cette figure et sur la figure 2.

Comme dans la mémoire de la figure 2, les électrodes de chaque registre à décalages et du registre de lecture reposent sur une couche isolante 8 superposée à une couche semi-conductrice 7 de deuxième type (de type N dans le mode de réalisation préférentiel de l'invention), cette couche semi-conductrice de deuxième type reposant elle-même sur un substrat semi-conducteur d'un premier type (de type P dans un mode de réalisation préférentiel de l'invention), non représenté sur cette figure. Des zones 32, 33, 34, 35, ... semi-conductrices d'un troisième type (de type N⁻ dans le mode de réalisation préférentiel de l'invention), qui présente un dopage moins important que la couche semi-conductrice 7, sont implantées en regard des électrodes de transfert 22, 26, 27, 28 du registre de lecture. On a également désigné sur cette figure comme sur la figure 2, les tensions V1, V2, V3, V4, appliquées respectivement aux électrodes 11, 12, 13, 14 de transfert et de stockage de l'un des groupes d'électrodes d'un registre à décalages, ainsi que la tension VF appliquée à l'électrode finale 16 du registre considéré (le registre 1 sur la figure 1). Ces tensions sont bien entendu, comme pour la mémoire de la figure 2, cycliques, déphasées, et présentent des valeurs extrêmes identiques. La phase de la tension VF est identique à la phase de la tension V1.

On a également désigné par VL1, VL2, des tensions VI1 et VI2 cycliques présentant des valeurs extrêmes identiques, appliquées aux paires d'électrodes telles que 22,25, 26,29, ... du registre de lecture 5. Ces tensions sont, comme dans la mémoire de la figure 2, en opposition de phases.

Selon l'invention, et dans un but qui sera expliqué plus loin en détail, la mémoire comporte, en regard de l'électrode finale 16 de chaque registre à décalage, une zone implantée d'un quatrième type (N⁻⁻ dans le mode de réalisation préférentiel de l'invention), qui présente un dopage moins important que les zones implantées de troisième type (les zones 32). Cette zone 40 permet, en relation avec le potentiel VF appliqué à l'électrode 16 du registre à décalages considéré, de diminuer le potentiel de transfert des charges entre le registre à décalages et le registre de lecture. Cette diminution du potentiel, notamment dans le mode de réalisation préférentiel de l'invention, évite que des charges (des électrons) présentes dans le registre de lecture, ne remontent vers le registre à décalage correspondant.

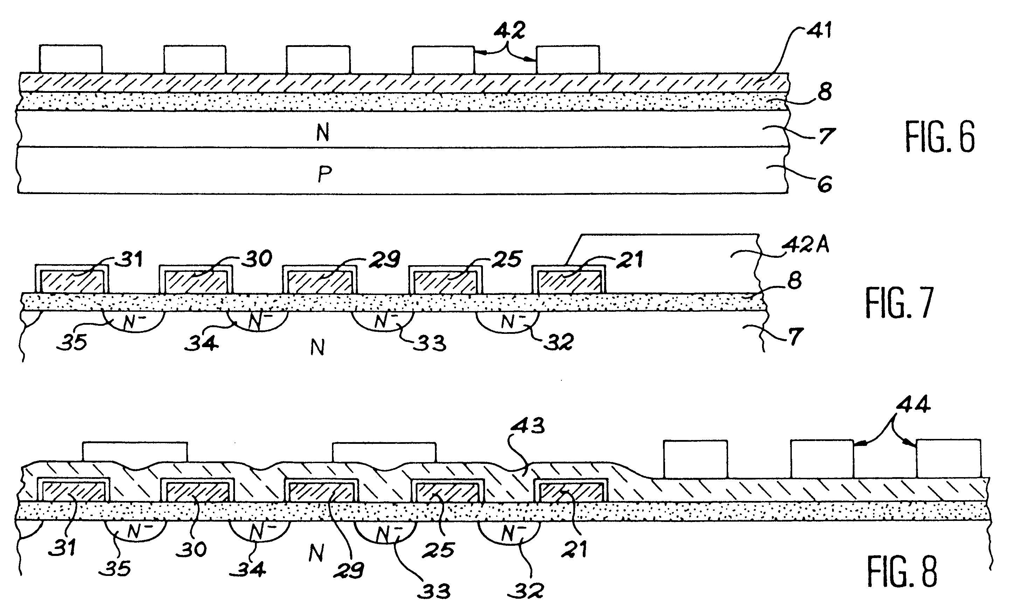

La figure 5 représente schématiquement un diagramme des potentiels V apparaissant à l'interface entre la couche semi-conductrice 7 et la couche isolante 8 dans la mémoire de l'invention, telle que représentée sur la figure 4. Ce diagramme fait apparaître les puits de potentiel et les potentiels de transfert pour le registre de lecture 5 et pour le registre à décalages 1. On a représenté, comme sur la figure 3, des puits de potentiel P1, P2, P3, P4 de profondeur VA et les paliers de potentiel de transfert apparaissant sous les paires d'électrodes du registre de lecture et sous les électrodes du registre à décalages, pour les tensions déphasées VI1, VI2, VF, V1, V2, V3, V4. Les diagrammes ϕ1, ϕ2 représentent respectivement ces puits et potentiels de transfert, pour chacune de ces tensions déphasées.

On constate sur cette figure que le palier de potentiel de valeur $V_D$ sous l'électrode finale 16 du registre à décalages 1, a une valeur inférieure à la valeur VC du palier correspondant de la mémoire de la figure 2 (mémoire connue). Ce résultat est obtenu grâce à l'implantation de la zone 40 de quatrième type, sous l'électrode finale 16. Cette valeur inférieure du palier de potentiel sous l'électrode finale 16 permet d'éviter que des électrons contenus dans le puits de potentiel P1 par exemple, lorsque ce puits en contient un nombre important, ne retournent vers le registre à décalages 1, c'est-à-dire dans le puits de potentiel P4.

Les figures 6 à 11 représentent schématiquement les étapes essentielles du procédé de fabrication de la mémoire de l'invention.

Comme représenté sur la figure 6, le procédé consiste tout d'abord à déposer sur une couche isolante 8 superposée à une couche semi-conductrice 7 dopée de type N, elle-même superposée à un substrat semi-conducteur 6 de type P de préférence, une première couche 41 d'un silicium polycristallin, dite de premier niveau. On découpe alors dans cette couche 41, par masquage (masque 42) et par gravure, les électrodes de stockage telles que 21, 25, 29, 30, 31 du registre de lecture (registre 5 sur la figure 1).

Les électrodes ainsi obtenues sont représentées sur la figure 7. On réalise ensuite, dans la couche semi-conductrice 7 dopée de deuxième type (de type N), des zones implantées de troisième type (de type N⁻), entre les électrodes de stockage 21, 25, 29, 30, 31 déjà réalisées. Ces zones dopées de troisième type sont représentées en 32, 33, 34, 35 sur la figure 7 ; on suppose que les électrodes de stockage déjà réalisées sont recouvertes d'une couche isolante obtenue de façon connue et qu'un masque de résine 42A protège les zones de la couche semi-conductrice où on ne souhaite pas réaliser des implantations de troisième type.

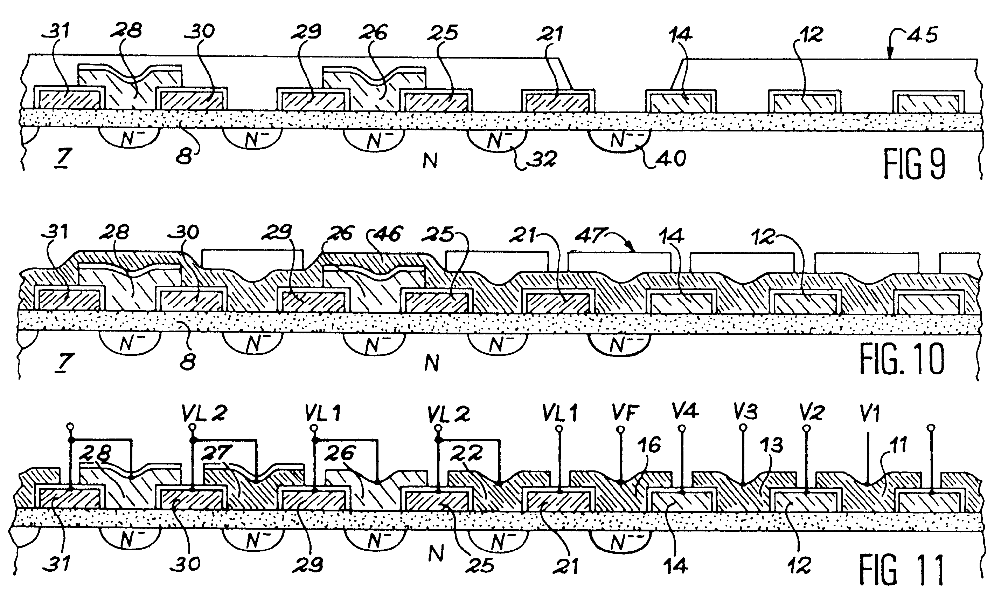

On dépose ensuite, comme le montre la figure 8, sur les électrodes déjà réalisées et sur les parties de la couche isolante 8 non recouvertes, une couche 43 d'un silicium polycristallin, dite de deuxième niveau. On découpe ensuite par masquage (masque 44), certaines des électrodes de transfert telles que 26, 28 du registre de lecture 5, ainsi que certaines des électrodes telles que 12, 14 de stockage et de transfert des registres à décalages.

Ces électrodes de deuxième niveau sont visibles sur la figure 9. On réalise ensuite une zone dopée 40 d'un quatrième type (de type N⁻⁻ dans le mode de réalisation préférentiel de l'invention), présentant un dopage moins important que les zones 2 dopées de troisième type (type N⁻), dans la couche semi-conductrice 7 de deuxième type, en regard des espaces correspondant aux électrodes finales des registres à décalages. Pour cette implantation, les électrodes déjà réalisées sont recouvertes d'une couche isolante et protégées par un masque 45.

Comme le montre la figure 10, on dépose ensuite sur les électrodes déjà réalisées dans les couches 41, 43 de silicium de premier et deuxième niveaux, et sur les parties de la couche isolante 8 non recouvertes par ces électrodes, une troisième couche 46 d'un silicium polycristallin, dite de troisième niveau. On réalise ensuite par masquage (masque 47) et par gravure de cette troisième couche de silicium polycristallin 46, d'autres électrodes de transfert telles que 22, 23 du registre de lecture, les électrodes finales 16 des registres à décalages, ainsi que les électrodes manquantes 11, 13, de stockage et de transfert des registres à décalages. Ces électrodes sont visibles sur la figure 11.

On met alors en place les fils de connexion qui permettent de relier les électrodes à des sources d'alimentation fournissant les tensions V1, V2, V3, V4, VF, Vl1, Vl2.

Le procédé de fabrication qui vient d'être décrit montre bien que cette mémoire comprend des registres à décalages fonctionnant avec des tensions V1, V2, V3, V4, VF ayant des phases différentes et que ces registres présentent deux niveaux d'intégration qui sont les deuxième et troisième niveaux 43, 46 de silicium polycristallin (l'électrode 14 par exemple appartient au deuxième niveau tandis que l'électrode 13 appartient au troisième niveau).

Le registre de lecture 5 est un registre qui fonctionne grâce à deux tensions de commande VL1, VL2 en opposition de phase, appliquées à des paires d'électrodes de ce registre. Ce registre de lecture peut être qualifié de registre à trois niveaux d'intégration puisque les différentes électrodes qui le constituent sont réalisées dans le premier niveau 41 de silicium polycristallin (l'électrode 29 par exemple), dans le deuxième niveau 43 de silicium polycristallin (électrode 28 par exemple), et dans le troisième niveau 46 de silicium polycristallin (l'électrode 23 par exemple).

## Revendications

1. Mémoire à transfert de charges comportant une succession de registres à décalages (1, 2, 3, ...) à transfert de charges dits à quatre phases et un registre (5) de lecture des charges des registres à décalages dit à deux phases, ces registres à décalages et ce registre de lecture étant réalisés sur un substrat semi-conducteur (6) dopé d'un premier type supportant une couche semi-conductrice (7) dopée d'un deuxième type, elle-même recouverte par une couche isolante (8), chaque registre (1) à décalages comportant en outre, parallèlement à un premier axe (Y), des groupes (a) successifs d'électrodes, comprenant chacun quatre électrodes de transfert et de stockage (11, 12, 13, 14) des charges, en contact avec la couche isolante (8), pour faire circuler les charges dans un sens prédéterminé (15), grâce à des potentiels de transfert et des puits de potentiel apparaissant sous ces électrodes, en relation avec les quatre phases de tensions (V1, V2, V3, V4) cycliques de valeurs identiques, appliquées respectivement aux électrodes de chaque groupe (9), les charges étant ainsi amenées à une extrémité du registre à décalages (1) considéré qui se termine par une électrode finale (16) de transfert, portée à un potentiel variable (VF) prédéterminé, le registre de lecture (5) comportant, le long d'un deuxième axe (X), pour chaque registre à décalages, et pour faire circuler les charges toujours dans un même sens (17) le long de ce deuxième axe, au moins une paire d'électrodes de lecture (20, 21) en contact avec la couche isolante (8), cette paire comprenant une électrode de stockage de lecture (21) contiguë à l'électode finale (16) du registre à décalages considéré, et une électrode de transfert de lecture (20) contiguë à l'électrode de stockage de lecture (21) correspondant au registre à décalages considéré, les électrodes de transfert de lecture (20) situées entre deux registres à décalage (1,2) étant adjacentes aux électrodes de stockage (18,21) correspondant à ces registres, des zones semi-conductrices (32, 33, ...) de troisième type étant réalisées respectivement en regard des électrodes de transfert (22, 26, ...) du registre de lecture dans la couche semiconductrice, les charges circulant dans ce registre de lecture grâce à des puits de potentiel et des potentiels de transfert apparaissant sous les paires successives d'électrodes, chaque paire d'électrodes de lecture (21, 20) correspondant à un registre à décalages, étant alimentée par une tension cyclique (VL1) présentant des valeurs égales mais en opposition de phases avec une tension cyclique (VL2) alimentant la paire d'électrodes de lecture (18, 23) du registre à décalages adjacent dans ladite succession, caractérisé en ce que chaque registre à décalages comporte en outre une zone dopée de quatrième type (40), réalisée dans la couche dopée (7) de deuxième type, en regard de l'électrode finale (16).

2. Mémoire selon la revendication 1, caractérisée en ce que le substrat semi-conducteur (6) de premier type est dopé de type P, la couche semi-conductrice (7) de deuxième type est dopée de type N, les zones (32, 33, ...) de troisième type étant dopées de type N$^-$, et présentant un dopage moins important que celui de la couche semi-conductrice (7) de deuxième type N, chaque zone (40) de quatrième type étant de type N$^{--}$ et présentant un dopage moins important que celui des zones (32, 33) dopées de troisième type N$^-$.

3. Procédé de fabrication d'une mémoire à transfert de charges, conforme à l'une quelconque des revendications 1 et 2, consistant à réaliser des électrodes de stockage (21, 25, 29, ...) du registre de lecture (5) par masquage (42) et gravure d'une première couche (41) de silicium polycristallin dite de premier niveau, déposée sur la couche isolante (8), puis à implanter lesdites zones (32, 33, ...) dopées de troisième type entre les électrodes de stockage du registre de lecture, dans la couche semi-conductrice (7) dopée de deuxième type, puis à réaliser des électrodes (26, 28, ...) de transfert du registre de lecture, et des électrodes de stockage et de transfert (12, 14, ...) des registres à décalages (1), par masquage (44) et gravure d'une deuxième couche (43) de silicium polycristallin, dite de deuxième niveau, déposée sur les électrodes déjà réalisées dans la première couche (41) et sur la couche isolante (8), caractérisé en ce qu'il consiste ensuite à réaliser une zone (40) dopée de quatrième type dans la couche semi-conductrice (43) de deuxième type, en regard d'espaces correspondant respectivement aux électrodes finales (16) des registres à décalages, puis à réaliser d'autres électrodes de transfert (22, 23, ...) du registre de lecture (5) et d'autres électrodes de transfert et de stockage (11, 13, ...) des registres à décalages, ainsi que les électrodes finales (16) des registres à décalages, par masquage (47) et gravure d'une troisième couche (46) de silicium polycristallin, dite de troisième niveau, déposée sur les électrodes déjà réalisées dans les première et deuxième couches de silicium polycristallin et sur la couche isolante (8).

**Patentansprüche**

1. Ladungstransferspeicher mit einer Folge von Ladungstransfer-Schieberegistern ( 1,2,3,...) vom Vierphasentyp und mit einem Register (5) vom Zweiphasentyp zum lesen der Ladungen der Schieberegister, wobei die Schieberegister und das Leseregister auf einem Halbleitersubstrat (6) realisiert sind, das eine Dotierung eines ersten Typs aufweist und eine halbleitende Schicht (7) mit einer Dotierung eines zweiten Typs trägt, die ihrerseits von einer Isolierschicht (8) bedeckt ist, wobei jedes Schieberegister (1) weiter parallel zu einer ersten Achse (Y) aueinanderfolgende Gruppen (9) von Elektroden mit je vier Ladungstransfer und- Speicherelektroden (11,12,13,14) enthalten, welche mit der Isolierschicht (8) in Kontakt stehen, um die Ladungen in einer vorgebenen Richtung (15) zu verschieben auf Grund von Transferpotentialen und von Potentialsenken, die sich unter diesen Elektroden befinden, in Verbindung mit den vier zyklischen Spannungsphasen (V1, V2, V3, V4) gleicher Werte, die an die einzelnen Elektroden jeder Gruppe (9) angelegt werden, wodurch die Ladungen in Richtung auf ein Ende des betrachteten Schieberegisters (1) befördert werden das in einer End-Transferelektrode (16) mündet, welche auf einem vorgegebenen variablen Potential (VF) liegt, wobei das Leseregister (5) entlang einer zweiten Achse (X) für jedes Schieberegister und zur Verschiebung der Ladungen stets in derselben Richtung (17) entlang dieser zweiten Achse mindestens ein Paar von Leseelektroden (20, 21) in Kontakt mit der Isolierschicht (8) aufweist, das eine Lesespeicherelektrode (21) angrenzend an die Endelektrode (16) des betrachteten Schieberegisters sowie eine Lesetransferelektrode (20) angrenzend an die dem betrachteten Schieberegister entsprechende Lesespeicherelektrode (21) aufweist, wobei die Lesetransferelektroden (20), die zwischen zwei Schieberegistern (1,2) liegen den diesen Registern entsprechenden Speicherelektroden (18, 21) benachbart sind, wobei Halbleiterzonen (32, 33) eines dritten Typs gegenüber den Transferelektroden (22, 26) des Leseregisters in der halbleitenden Schicht liegen, wobei die Ladungen in diesem Leseregister aufgrund der Potentialsenken und der Transferpotentiale verschoben werden, die unter den aufeinanderfolgenden Paaren von Elektroden liegen, wobei jedes Paar von Leseelektroden (21, 20) entsprechend einem Schieberegister von einer zyklischen Spannung (VL1) gespeist wird, die die gleichen Werte, aber entgegengesetzte Phase wie eine zyklische Spannung (VL2) besitzt, die das Leseelektrodenpaar (18, 23) des benachbarten Schieberegisters in der Folge speist, dadurch gekennzeichnet, daß jedes Schieberegister außerdem eine Zone mit einer Dotierung eines vierten Typs (40) aufweist, die in der Schicht (7) realisiert ist, welche gemäß dem zweiten Typ dotiert ist, und gegenüber der Endelektrode (16) liegt.

2. Speicher nach Anspruch 1, dadurch gekennzeichnet, daß das Halbleitersubstrat (6) des ersten Typs eine Dotierung vom P-Typ besitzt, daß die Halbleiterschicht (7) des zweiten Typs eien Dotierung vom N-Typ besitzt, daß die Zonen (32, 33...) des dritten Typs eine Dotierung vom Typ $N^-$ und einen Dotierungsgrad besitzen, der geringer als der der Halbleiterschicht (7) des zweiten Typs, also N, ist, und daß jede Zone (40) des vierten Typs eine Dotierung des Typs $N^{--}$ besitzt und einen Dotierungsgrad, der geringer als der der Zonen (32, 33) mit der Dotierung des dritten Typs, also $N^-$, ist.

3. Verfahren zur Herstellung eines Ladungstransferspeichers nach einem beliebigen der Ansprüche 1 und 2, bei dem Speicherelektroden (21, 25, 29,...) des Leseregisters (5) durch Maskierung (42) und Ätzen einer ersten Schicht (41) aus polykristalinem Silizium, erstes Niveau genannt, hergestellt werden, wobei diese Schicht auf der isolierenden Schicht (8) liegt, worauf die mit dem dritten Dotierungstyp dotierten Zonen (32, 33 ...) zwischen die Speicherelektroden des Leseregisters in der Halbleiterschicht (7) implantiert werden, die vom zweiten Dotierungstyp ist, worauf Transferelektroden (26, 28) des Leseregisters und Speicher-und Transferelektroden (12, 14...) der Schieberegister (1) durch Maskierung (44) und Ätzen einer zweiten Schicht (43) aus polykristallinem Silizium, zweites Niveau genannt, ausgebildet werden, wobei diese Schicht auf die bereits hergestellten Elektroden in der ersten Schicht (41) und auf der Isolierschicht (8) aufgebracht wird, dadurch gekennzeichnet, daß dann eine Zone (40) mit einer Dotierung des vierten Typs in der Halbleiterschicht (43) des zweiten Typs gegenüber von Stellen realisiert wird, die je einer der Endelekroden (16) der Schieberegister entsprechen, worauf andere Transferelektroden (22, 23...) des Leseregisters (5) und andere Transfer- und Speicherelektroden (11, 13...) der Schieberegister sowie die Endelektroden (16) der Schieberegister durch Maskierung (47) und Ätzen einer dritten Schicht (46) aus polykristallinem Silizium, drittes Niveau genannt, realisiert werden, wobei diese Schicht auf die bereits in der ersten und in der zweiten Schicht aus polykristallinem Silizium ausgebildeten Elektroden und auf die Isolierschicht (8) aufgebracht wird.

## Claims

1. Charge-transfer memory including a succession of what are termed four-phase charge-transfer shift registers (1, 2, 3, etc.) and what is termed a two-phase register (5) for reading the charges of the shift registers, these shift registers and this read register being produced on a doped semiconductor substrate (6) of a first type supporting a doped semiconductor layer (7) of a second type, which layer is covered by an insulating layer (8), each shift register (1) furthermore including, parallel to a first axis (Y), successive groups (9) of electrodes, each comprising four electrodes for transferring and storing (11, 12, 13, 14) the charges, in contact with the insulating layer (8), in order to cause the charges to flow in a predetermined direction (15), by virtue of transfer potentials and potential wells appearing under these electrodes, with respect to the four phases of cyclic voltages (V1, V2, V3, V4) of an identical value which are applied respectively to the electrodes of each group (9), the charges thus being brought to one end of the shift register (1) in question which ends in a final transfer electrode (16) which is raised to a predetermined variable potential (VF), the read register (5) including, along a second axis (X), for each shift register and in order to cause the charges to flow, still in a same direction (17), along this second axis, at least one pair of read electrodes (20, 21) in contact with the insulating layer (8), this pair comprising a read storage electrode (21) contiguous with the final electrode (16) of the shift register in question, and a read transfer electrode (20) contiguous with the read storage electrode (21) corresponding to the shift register in question, the read transfer electrodes (20) located between two shift registers (1, 2) being adjacent to the storage electrodes (18, 21) corresponding to these registers, semiconducting zones (32, 33, etc.) of a third type being produced respectively opposite the transfer electrodes (22, 26, etc.) of the read register in the semiconducting layer, the charges flowing in this read register by virtue of potential wells and transfer potentials which appear under the successive electrode pairs, each pair of read electrodes (21, 20) corresponding to one shift register and being supplied by a cyclic voltage (VL1) having equal values but in phase opposition with a cyclic voltage (VL2) supplying the pair of read electrodes (18, 23) of the adjacent shift register in the said succession, characterised in that each shift register furthermore includes a doped zone (40) of a fourth type, produced in the doped layer (7) of the second type, opposite the final electrode (16).

2. Memory according to Claim 1, characterised in that the semiconductor substrate (6) of the first type is P-type doped, the semiconductor layer (7) of the second type is N-type doped, the zones (32, 33, etc.) of the third type being $N^-$-type doped and having a lower doping than that of the semiconductor layer (7) of the second N type, each zone (40) of the fourth type being of $N^{--}$ type and having a lower doping than that of the doped zones (32, 33) of the third $N^-$ type.

3. Process for manufacturing a charge-transfer memory, according to either one of Claims 1 and 2, consisting in producing storage electrodes (21, 25, 29, etc.) of the read register (5) by masking (42) and etching a first layer (41) of what is termed first level polycrystalline silicon , which layer is deposited onto the insulating layer (8), then in implanting the said doped zones (32, 33, etc.) of the third type, between the storage electrodes of the read register, in the doped semiconductor layer (7) of the second type, then in producing transfer electrodes (26, 28, etc.) of the read register, and storage and transfer electrodes (12, 14, etc.) of the shift registers (1), by masking (44) and etching a second layer (43) of what is termed second level polycrystalline silicon, which layer is deposited onto the electrodes already produced in the first layer (41) and onto the insulating layer (8), characterised in that it then consists in producing a doped zone (40) of the fourth type in the semiconductor layer (43) of the second type, opposite spaces corresponding respectively to the final electrodes (16) of the shift registers, and then in producing other transfer electrodes (22, 23, etc.) of the read register (5) and other transfer and storage electrodes (11, 13, etc.) of the shift registers, as well as the final electrodes (16) of the shift registers, by masking (47) and etching a third layer (46) of what is termed third level polycrystalline silicon, which layer is deposited onto the electrodes already produced in the first and second layers of polycrystalline silicon and onto the insulating layer (8).

FIG. 1

FIG. 2

FIG. 3

EP 0 325 524 B1

EP 0 325 524 B1

## FIG. 4

VL1  VL2  VL1  VL2  VL1  VF  V4  V3  V2  V1

28  27  26  22  16  13  11

31  30  N⁻  N⁻  N  N⁻  N⁻  N⁻  14  12  8  7

35  34  29  25  32  21  40

33

## FIG. 5

X

0

VD

VC  ∅2  ∅1

VB

VA

P3  P2  P1  P4

12

EP 0 325 524 B1

**42**

**41**

**8**

N **7**

P **6**

**FIG. 6**

**31** **30** **29** **25** **21** **42A**

**8**

N⁻ N⁻ N⁻ N⁻ **7**

**35** **34** N **33** **32**

**FIG. 7**

**43** **44**

N⁻ N⁻ N⁻ N⁻

**31** **35** **30** **34** N **29** **25** **21** **33** **32**

**FIG. 8**

EP 0 325 524 B1

**FIG 9**

31  28  30  29  26  25  21  14  12  45

7  N⁻  8  N⁻  N⁻  N  N⁻  32  N⁻  40

**FIG. 10**

31  28  30  29  26  46  25  21  47  14  12

7  N⁻  8  N⁻  N⁻  N  N⁻

**FIG 11**

VL2  VL1  VL2  VL1  VF  V4  V3  V2  V1

28  27  26  22  16  13  11

31  N⁻  30  N⁻  29  N⁻  N  25  21  N⁻  14  N⁻  12